# EUROPEAN PATENT APPLICATION

(11) **EP 4 773 795 A1**
(43) Date of publication of application: **08.07.2026**
(21) Application number: 25226656.4
(22) Date of filing: 23.12.2025
(51) Int. Cl.: H10W 40/47, H10W 40/22, H10W 40/00, H05K 7/20, H10W 40/25, H10W 74/10, H10W 90/10, H10W 42/00

(54) **POWER MODULE AND POWER CONVERSION DEVICE**

(30) Priority: 07.01.2025 CN 202520034428 U
(71) Applicant: Huawei Technologies Co., Ltd., Shenzhen, Guangdong 518129 (CN)
(72) Inventor: YUAN, Ziyi, Shenzhen, 518129 (CN); ZHU, Xuefeng, Shenzhen, 518129 (CN); FANG, Chao, Shenzhen, 518129 (CN); LIU, Zhiling, Shenzhen, 518129 (CN); ZHOU, Jiakan, Shenzhen, 518129 (CN); DING, Han, Shenzhen, 518129 (CN); WANG, Jianli, Shenzhen, 518129 (CN)
(74) Representative: Isarpatent

(57) **Abstract**

This application provides a power module and a power conversion device, and relates to the field of electronic technologies. The power module includes a power component, an insulating substrate, a composite substrate, and a heat sink. In a thickness direction of the insulating substrate, the power component, the insulating substrate, the composite substrate, and the heat sink are sequentially disposed. The heat sink includes an accommodation cavity and a mounting hole, and at least a part of the composite substrate is accommodated in the mounting hole and seals the accommodation cavity. The composite substrate includes a first connecting piece and a second connecting piece that are connected. In the thickness direction of the insulating substrate, the first connecting piece is connected to the insulating substrate, a side wall of the second connecting piece is connected to a hole wall of the mounting hole, and a material of the second connecting piece is the same as a material of the heat sink. In a direction perpendicular to the thickness direction of the insulating substrate, a maximum size of the second connecting piece is greater than or equal to a maximum size of the first connecting piece. The power module in this application has higher heat dissipation efficiency, structural stability and performance of the power conversion device are better, assembly is convenient, and costs are low.

## Description

### TECHNICAL FIELD

This application relates to the field of electronic technologies, and in particular, to a power module and a power conversion device.

### BACKGROUND

In the conventional technology, a thermal interface material (TIS) is filled between an insulating substrate and a heat sink, and heat of a power component is diffused to the heat sink through the insulating substrate and the thermal interface material, and then diffused from the heat sink to the outside, to dissipate heat of the power component. However, a low thermal conductivity of the thermal interface material leads to low heat dissipation efficiency on the power component.

### SUMMARY

This application provides a power module and a power conversion device, to resolve a problem of low heat dissipation efficiency on a power component.

According to a first aspect, an embodiment of this application provides a power module. The power module includes a power component, an insulating substrate, a composite substrate, and a heat sink. In a thickness direction of the insulating substrate, the power component, the insulating substrate, the composite substrate, and the heat sink are sequentially disposed. The heat sink includes an accommodation cavity and a mounting hole. In the thickness direction of the insulating substrate, the mounting hole is located on a side of the accommodation cavity and communicates with the accommodation cavity, and at least a part of the composite substrate is accommodated in the mounting hole and seals the accommodation cavity. The composite substrate includes a first connecting piece and a second connecting piece that are connected. In the thickness direction of the insulating substrate, the first connecting piece is connected to the insulating substrate, a side wall of the second connecting piece is connected to a hole wall of the mounting hole, and a material of the second connecting piece is the same as a material of the heat sink. In a direction perpendicular to the thickness direction of the insulating substrate, a maximum size of the second connecting piece is greater than or equal to a maximum size of the first connecting piece.

The power module provided in this embodiment of this application is used in a power conversion device. A coolant is accommodated in the accommodation cavity. The at least a part of the composite substrate is accommodated in the mounting hole and seals the accommodation cavity, so that the coolant in the accommodation cavity can be in contact with the composite substrate, and heat generated during operating of the power component is transferred to the coolant through the composite substrate, and then transferred to an external environment through the coolant. The heat generated during operating of the power component may not pass through the heat sink. This helps shorten a heat dissipation path of the power component, and the heat of the power component can be diffused to the coolant more quickly. This helps improve heat dissipation efficiency on the power component.

In addition, the material of the second connecting piece is designed to be the same as the material of the heat sink, so that the second connecting piece can be fastened to the heat sink. This helps improve connection strength between the second connecting piece and the heat sink, and helps improve structural stability and reliability. In addition, assembly is facilitated, processing efficiency is higher, and costs are reduced.

In some embodiments, a thermal conductivity of the first connecting piece is greater than a thermal conductivity of the second connecting piece. A design in which the thermal conductivity of the first connecting piece is greater than the thermal conductivity of the second connecting piece causes the first connecting piece to have better thermal conductivity performance, and the heat of the power component can be more quickly diffused to the coolant through the first connecting piece, thereby improving the heat dissipation efficiency on the power component.

In some embodiments, the first connecting piece and the second connecting piece enclose an accommodation groove. In the thickness direction of the insulating substrate, an opening of the accommodation groove faces away from the accommodation cavity, and at least a part of the insulating substrate is disposed in the accommodation groove and is fastened and stacked to the first connecting piece. The first connecting piece and the second connecting piece enclose the accommodation groove. In the thickness direction of the insulating substrate, the opening of the accommodation groove faces away from the accommodation cavity, and the at least a part of the insulating substrate is disposed in the accommodation groove and is fastened and stacked to the first connecting piece. This reduces a size of the power module in the thickness direction of the insulating substrate, and makes a structure compact, thereby facilitating a miniaturization design.

In some embodiments, the second connecting piece is fastened and stacked to a side that is of the first connecting piece and that faces away from the accommodation cavity, and the accommodation groove penetrates the second connecting piece in the thickness direction of the insulating substrate. A design in which the second connecting piece is fastened and stacked to the side that is of the first connecting piece and that faces away from the accommodation cavity, and the accommodation groove penetrates the second connecting piece in the thickness direction of the insulating substrate implements sealing of the accommodation cavity only via the first connecting piece. This helps increase a contact area between the first connecting piece and the coolant in the accommodation cavity, and helps improve the heat dissipation efficiency on the power component. In addition, the structure is simple, processing is facilitated, the processing efficiency is improved, and the processing costs are reduced.

In some embodiments, the second connecting piece encloses and wraps at least a part of a side wall of the first connecting piece. In a design in which the second connecting piece encloses and wraps the at least a part of the side wall of the first connecting piece, when the first connecting piece is under pressure of the coolant in the accommodation cavity, it is more difficult for the first connecting piece to deform, to avoid damage to the insulating substrate and the power component caused by deformation of the first connecting piece. This helps prolong a service life of the power module.

In some embodiments, a size of the second connecting piece in the thickness direction of the insulating substrate is greater than a size of the first connecting piece in the thickness direction of the insulating substrate. A design in which the size of the second connecting piece in the thickness direction of the insulating substrate is greater than the size of the first connecting piece in the thickness direction of the insulating substrate causes the first connecting piece to be better wrapped by the second connecting piece, and when the first connecting piece is under pressure of the coolant in the accommodation cavity, it is more difficult for the first connecting piece to deform, to avoid the damage to the insulating substrate and the power component caused by the deformation of the first connecting piece, and further prolong the service life of the power module. In addition, this helps increase a connection area between the second connecting piece and the hole wall of the mounting hole, helps improve connection strength, and helps improve structural stability of the power module.

In some embodiments, the power module further includes a packaging member, and the packaging member wraps the insulating substrate and the power component. The packaging member can protect the power component, and avoid damage to the power component. This helps prolong the service life of the power module, and further prolong a service life of the power conversion device.

In some embodiments, a retaining wall is disposed on a surface that is of the first connecting piece and that faces the insulating substrate. The retaining wall surrounds the insulating substrate, and the retaining wall and the second connecting piece are spaced. The packaging member wraps the retaining wall. A design in which the retaining wall is disposed on the surface that is of the first connecting piece and that faces the insulating substrate, and the packaging member wraps the retaining wall improves binding force between the packaging member and the composite substrate, and improves stability of a connection between the packaging member and the composite substrate.

In some embodiments, a first protrusion is disposed on a side of the retaining wall in a thickness direction of the retaining wall, and the first protrusion faces the insulating substrate. A part of the packaging member is located between the first protrusion and the first connecting piece. The first protrusion is disposed, and the first protrusion limits the packaging member in the thickness direction of the insulating substrate. This helps improve the stability of the connection between the packaging member and the composite substrate.

In some embodiments, the retaining wall and a groove side wall of the accommodation groove are spaced. A circulation hole is disposed on the retaining wall. The circulation hole penetrates the retaining wall in the thickness direction of the retaining wall, and the circulation hole penetrates the retaining wall in the thickness direction of the insulating substrate. The circulation hole is disposed. This helps improve fluidity of the packaging member in the accommodation groove, so that the packaging member can fill the entire accommodation groove, and a hole is prevented. This helps improve the binding force between the packaging member and the composite substrate, thereby improving reliability.

In some embodiments, a second protrusion is disposed on the groove side wall of the accommodation groove, and the second protrusion faces the insulating substrate. A part of the packaging member is located between the second protrusion and the first connecting piece. The second protrusion is disposed, and the second protrusion limits the packaging member in the thickness direction of the insulating substrate, thereby further improving the stability of the connection between the packaging member and the composite substrate.

In some embodiments, the first connecting piece is fastened and stacked to the insulating substrate, and the second connecting piece is fastened and stacked to a side that is of the first connecting piece and that faces away from the insulating substrate. In a design in which the first connecting piece is fastened and stacked to the insulating substrate, and the second connecting piece is fastened and stacked to the side that is of the first connecting piece and that faces away from the insulating substrate, the second connecting piece seals the accommodation cavity, the second connecting piece can resist the pressure of the coolant in the accommodation cavity, and the pressure of the coolant does not directly act on the first connecting piece. This prevents the first connecting piece from being deformed, avoids the damage to the insulating substrate and the power component on the first connecting piece, and helps prolong the service life of the power module, thereby prolonging the service life of the power conversion device.

In some embodiments, a through hole is disposed on a surface that is of the second connecting piece and that faces away from the first connecting piece. The through hole is disposed, so that the coolant can flow into the through hole, and the first connecting piece can be in direct contact with the coolant. Therefore, a distance between the power component and the coolant is shorter, the heat dissipation path is shorter, and the heat of the power component can be diffused to the coolant more quickly, thereby improving heat dissipation effect and heat dissipation efficiency of the power module.

In some embodiments, the insulating substrate includes a thermally conductive layer, an insulation layer, and a conductive layer that are sequentially disposed in the thickness direction of the insulating substrate, the conductive layer faces the power component, the first connecting piece is fastened and stacked to a side that is of the thermally conductive layer and that faces away from the insulation layer, and the size of the first connecting piece in the thickness direction of the insulating substrate is greater than a size of the thermally conductive layer in the thickness direction of the insulating substrate. A design in which the size of the first connecting piece in the thickness direction of the insulating substrate is greater than the size of the thermally conductive layer in the thickness direction of the insulating substrate helps improve strength of the first connecting piece, helps improve reliability of the connection between the first connecting piece and the insulating substrate, and helps improve the structural stability and the reliability of the power module.

In some embodiments, there are a plurality of insulating substrates and a plurality of power components, at least one power component is disposed on a side that is of each insulating substrate and that faces away from the heat sink, and in the direction perpendicular to the thickness direction of the insulating substrate, the plurality of insulating substrates are sequentially spaced. The power module further includes a first conductive member, the first conductive member is disposed between two adjacent insulating substrates, one end of the first conductive member is connected to a conductive layer of one of the insulating substrates, and the other end of the first conductive member is connected to a conductive layer of the other insulating substrate.

A design in which the first conductive member is disposed between the two adjacent insulating substrates implements through-current between the two adjacent insulating substrates, so that in the two adjacent insulating substrates, the through-current can be implemented between a power component disposed on one insulating substrate and a power component disposed on the other insulating substrate. This helps reduce stray inductance in a circuit, to reduce oscillation and overvoltage risks in the circuit, and helps improve performance of the power module, thereby improving performance of the power conversion device.

In some embodiments, a first groove is disposed on the surface that is of the first connecting piece and that faces the insulating substrate, and the first groove is close to an edge of the insulating substrate. The first groove is disposed, so that stress generated at the edge of the insulating substrate can be released in the first groove, thereby preventing the stress from directly acting on the first connecting piece, and preventing the first connecting piece from being deformed and damaging the insulating substrate and the power component. This helps prolong the service life of the power module, and further prolongs the service life of the power conversion device.

According to a second aspect, an embodiment of this application further provides a power conversion device. The power conversion device includes a circuit board and the power module according to any embodiment of the first aspect, and the power module is mounted on the circuit board.

### BRIEF DESCRIPTION OF DRAWINGS

To describe technical solutions in embodiments of this application or in the background more clearly, the following describes accompanying drawings for describing embodiments of this application or the background.
FIG. 1 is a block diagram of a structure in which a power conversion device cooperates with a photovoltaic module and a power grid according to an embodiment of this application;
FIG. 2 is a diagram of a three-dimensional structure of a power conversion device shown in FIG. 1;
FIG. 3 is a diagram of a three-dimensional structure of a power module of the power conversion device shown in FIG. 2;
FIG. 4 is an exploded view of a three-dimensional structure of the power module shown in FIG. 3 from another perspective;
FIG. 5 is a sectional view of the power module shown in FIG. 3 cut along a line L1-L1;
FIG. 6 is an enlarged view of the power module shown in FIG. 5 in a position A;
FIG. 7 is an enlarged view of the power module shown in FIG. 5 in a position B;
FIG. 8 is an enlarged view of the power module shown in FIG. 4 in a position C;
FIG. 9 is a sectional view of the power module shown in FIG. 3 cut along the line L1-L1 according to another embodiment;
FIG. 10 is an enlarged view of the power module shown in FIG. 9 in a position D;
FIG. 11 is a sectional view of the power module shown in FIG. 3 cut along the line L1-L1 according to still another embodiment; and
FIG. 12 is a sectional view of the power module shown in FIG. 3 cut along the line L1-L1 according to yet another embodiment.

### DESCRIPTION OF EMBODIMENTS

Embodiments of this application provide a power module and a power conversion device. The power module is used in the power conversion device. In this application, that a material of a feature A is the same as a material of a feature B means that a principal component of the feature A is the same as a principal component of the feature B, and content of the principal component of the feature A may be equal to or unequal to content of the principal component of the feature B.

The following describes embodiments of this application with reference to accompanying drawings in embodiments of this application.

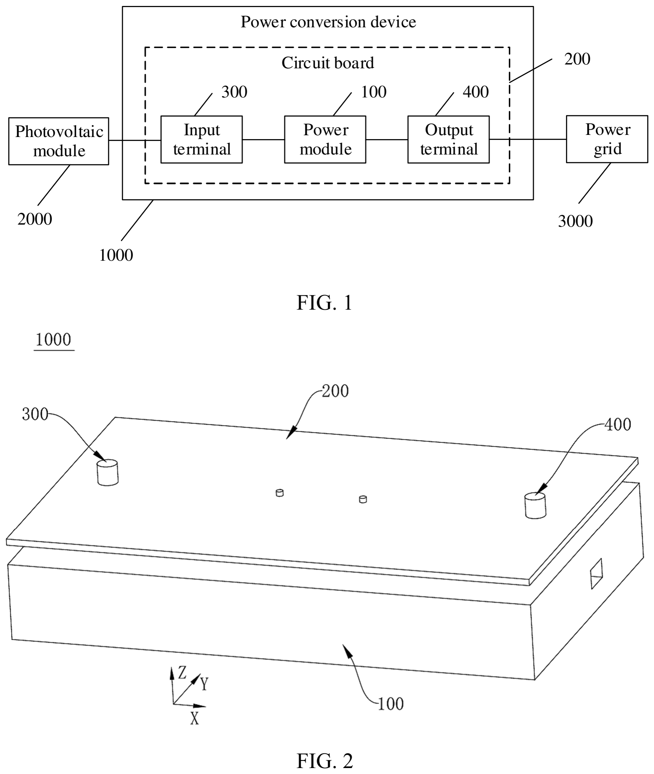

Refer to FIG. 1 and FIG. 2. FIG. 1 is a block diagram of a structure in which a power conversion device 1000 cooperates with a photovoltaic module 2000 and a power grid 3000 according to an embodiment of this application. FIG. 2 is a diagram of a three-dimensional structure of the power conversion device 1000 shown in FIG. 1.

For example, the power conversion device 1000 is a photovoltaic inverter. In some other embodiments, the power conversion device 1000 may alternatively be an electronic device used for power conversion, for example, a rectifier, a transformer, or another inverter. The power conversion device 1000 is configured to: convert a direct current output by the photovoltaic module 2000 into an alternating current, and supply the alternating current to the power grid 3000. In some other embodiments, the power conversion device 1000 may alternatively be configured to: convert a direct current output by the photovoltaic module 2000 into an alternating current, and supply the alternating current to a load device. The load device may be an electronic device that uses an alternating current, including but not limited to a motor, a fan, an air conditioner, or the like. In some other embodiments, the power conversion device 1000 may alternatively be used in an electric drive controller. The power conversion device 1000 may alternatively be configured to: convert a direct current output by a battery into an alternating current, and supply the alternating current to a motor.

In some embodiments, the power conversion device 1000 includes a power module 100, a circuit board 200, an input terminal 300, and an output terminal 400. The power module 100, the input terminal 300, and the output terminal 400 are all mounted on the circuit board 200. Specifically, the power module 100 is mounted on one side of the circuit board 200, and the input terminal 300 and the output terminal 400 are mounted on the other side of the circuit board 200. In some other embodiments, the power module 100, the input terminal 300, and the output terminal 400 may alternatively be mounted on a same side of the circuit board 200.

The input terminal 300 is configured to receive a direct current output by the photovoltaic module 2000. The power module 100 is configured to: receive the direct current transmitted from the input terminal 300, and convert the direct current into an alternating current. The output terminal 400 is configured to: receive the alternating current output by the power module 100, and transmit the alternating current to the power grid 3000. The power conversion device 1000 converts, via the power module 100, the direct current output by the photovoltaic module 2000 into the alternating current.

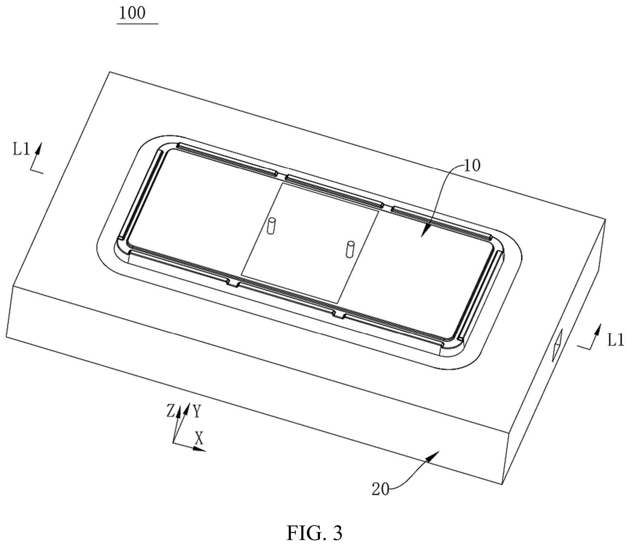

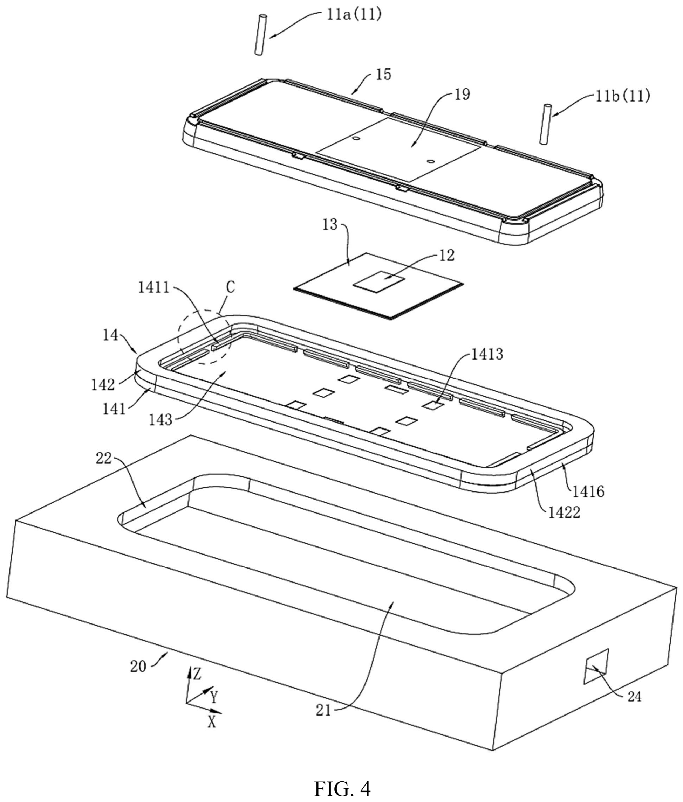

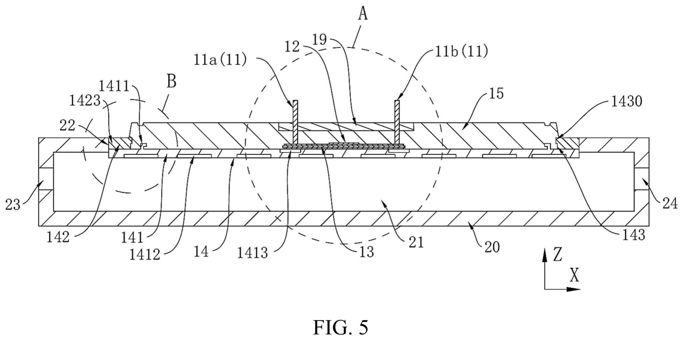

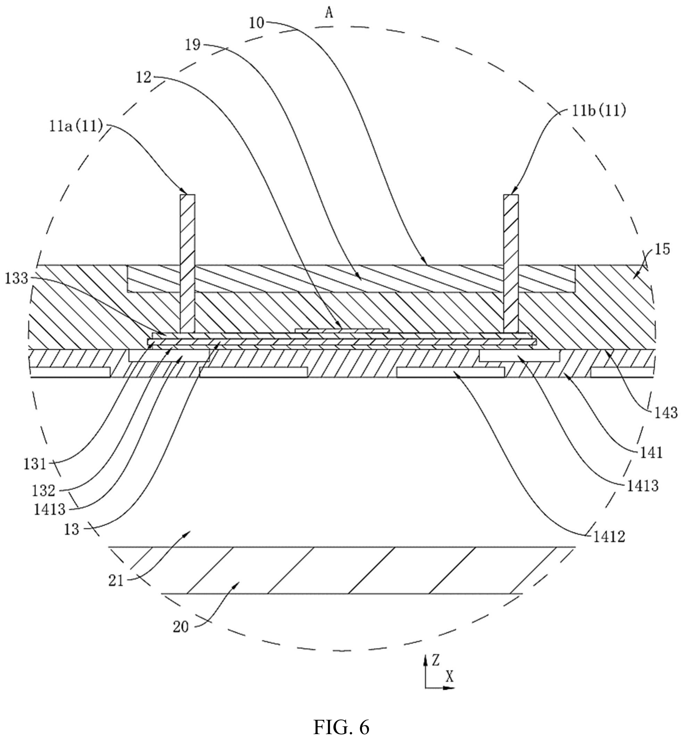

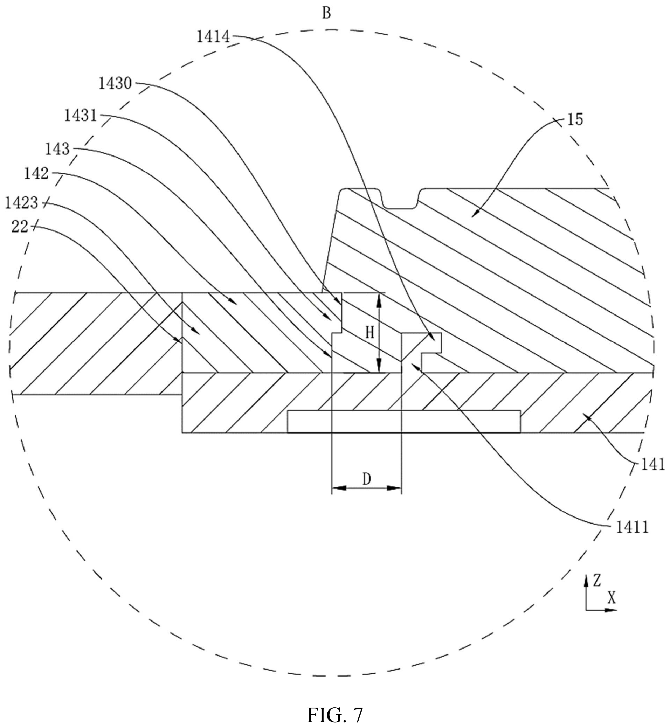

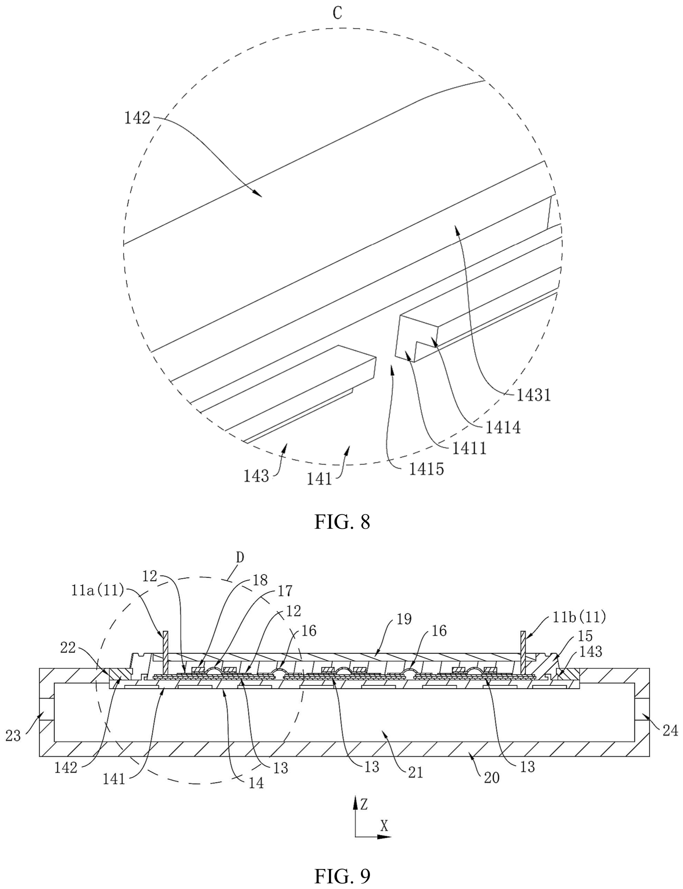

Refer to FIG. 3, FIG. 4, FIG. 5, FIG. 6, FIG. 7, and FIG. 8. With reference to FIG. 1 and FIG. 2, FIG. 3 is a diagram of a three-dimensional structure of the power module 100 of the power conversion device 1000 shown in FIG. 2. FIG. 4 is an exploded view of a three-dimensional structure of the power module 100 shown in FIG. 3 from another perspective. FIG. 5 is a sectional view of the power module 100 shown in FIG. 3 cut along a line L1-L1. FIG. 6 is an enlarged view of the power module 100 shown in FIG. 5 in a position A. FIG. 7 is an enlarged view of the power module 100 shown in FIG. 5 in a position B. FIG. 8 is an enlarged view of the power module 100 shown in FIG. 4 in a position C.

As shown in FIG. 3, FIG. 4, and FIG. 5, in some embodiments, the power module 100 includes a functional component 10 and a heat sink 20. The functional component 10 includes a terminal 11, a power component 12, an insulating substrate 13, a composite substrate 14, and a packaging member 15. In this embodiment, a thickness direction of the insulating substrate 13 is defined as a first direction (namely, a Z-axis direction shown in the figure), a direction perpendicular to the thickness direction of the insulating substrate 13 is defined as a second direction (namely, an X-axis direction shown in the figure), and a direction perpendicular to the first direction and the second direction is defined as a third direction (namely, a Y-axis direction shown in the figure). In this embodiment, the second direction (namely, the X-axis direction shown in the figure) is a length direction of the insulating substrate 13, and the third direction (namely, the Y-axis direction shown in the figure) is a width direction of the insulating substrate 13. In some other embodiments, the Y-axis direction shown in the figure may alternatively be the length direction of the insulating substrate 13, and the X-axis direction shown in the figure may alternatively be the width direction of the insulating substrate 13.

In the Z-axis direction, the power component 12, the insulating substrate 13, the composite substrate 14, and the heat sink 20 are sequentially disposed. The terminal 11 is disposed on a side that is of the insulating substrate 13 and that faces away from the heat sink 20 and is electrically connected to the power component 12. The packaging member 15 wraps the insulating substrate 13, the power component 12, and a part of the terminal 11. An end part that is of the terminal 11 and that faces away from the insulating substrate 13 is exposed outside the packaging member 15 and is mounted on the circuit board 200 (as shown in FIG. 2). A direct current transmitted from the input terminal 300 (as shown in FIG. 1) is transmitted to the power component 12 through the terminal 11. The power component 12 is configured to convert the direct current into an alternating current. The alternating current output by the power component 12 is transmitted to the output terminal 400 (as shown in FIG. 1) through the terminal 11. The output terminal 400 receives the alternating current output by the power component 12, and transmits the alternating current to the power grid 3000 (as shown in FIG. 1), to supply the alternating current to the power grid 3000. The heat sink 20 is configured to dissipate heat for the power component 12, to ensure that the power module 100 can operate normally. A size of the composite substrate 14 in the Z-axis direction may be less than or equal to 15 mm. In some other embodiments, the size of the composite substrate 14 in the Z-axis direction may alternatively be greater than 15 mm.

As shown in FIG. 4 and FIG. 5, in some embodiments, the heat sink 20 includes an accommodation cavity 21 and a mounting hole 22. In the Z-axis direction, the mounting hole 22 is located on a side of the accommodation cavity 21 and communicates with the accommodation cavity 21. The accommodation cavity 21 is configured to accommodate a coolant, and the coolant may be water, ethanol, or another coolant. The mounting hole 22 is in a rectangular shape. In some other embodiments, the mounting hole 22 may alternatively be in a circular shape, a triangular shape, of another special-shaped structure, or the like. Round corners are disposed at four corners of the mounting hole 22. In some other embodiments, the four corners of the mounting hole 22 may alternatively be set to oblique angles or right angles.

In some embodiments, the heat sink 20 further includes a first through hole 23 and a second through hole 24. Both the first through hole 23 and the second through hole 24 communicate with the accommodation cavity 21, are located on two sides of the mounting hole 22, and are both spaced from the mounting hole 22. Specifically, in the X-axis direction, the first through hole 23 and the second through hole 24 are located on two sides of the accommodation cavity 21 and are located on two sides of the mounting hole 22. In some other embodiments, in the Y-axis direction, the first through hole 23 and the second through hole 24 may alternatively be located on two sides of the accommodation cavity 21 and are located on two sides of the mounting hole 22. In some other embodiments, in the Z-axis direction, the first through hole 23 and the second through hole 24 may be located on one side or two sides of the accommodation cavity 21. In the X-axis direction or the Y-axis direction, the first through hole 23 and the second through hole 24 are located on the two sides of the mounting hole 22. The coolant may flow into the accommodation cavity 21 from the first through hole 23, and then flow out of the accommodation cavity 21 from the second through hole 24.

As shown in FIG. 5 and FIG. 6, in some embodiments, the insulating substrate 13 includes a thermally conductive layer 132, an insulation layer 131, and a conductive layer 133 that are sequentially disposed in the Z-axis direction. Specifically, in the Z-axis direction, the thermally conductive layer 132, the insulation layer 131, and the conductive layer 133 are sequentially fastened and stacked. The thermally conductive layer 132 faces the composite substrate 14, and the conductive layer 133 faces the power component 12. Projection of the thermally conductive layer 132 in the Z-axis direction overlaps projection of the conductive layer 133 in the Z-axis direction. For example, the insulation layer 131 is made of an insulation material including but not limited to ceramic or epoxy resin. The thermally conductive layer 132 and the conductive layer 133 are made of a same conductive material. Specifically, both the thermally conductive layer 132 and the conductive layer 133 are made of copper. It may be understood that a material of the thermally conductive layer 132 is the same as a material of the conductive layer 133. A design in which the thermally conductive layer 132 and the conductive layer 133 are made of the same material helps reduce material costs of the thermally conductive layer 132 and the conductive layer 133, helps reduce processing costs of the insulating substrate 13, and helps reduce processing costs of the power module 100. In some other embodiments, the thermally conductive layer 132 and the conductive layer 133 may alternatively be made of different conductive materials. In other words, the materials of the thermally conductive layer 132 and the conductive layer 133 may alternatively be different.

The power component 12 is an insulated gate bipolar transistor (IGBT) chip. In some other embodiments, the power component 12 may alternatively be another electronic device like a fast recovery diode (FRD) chip, a metal-oxide-semiconductor field-effect transistor (MOSFET) chip, or a triode. In a manner including but not limited to soldering, sintering, or brazing, the power component 12 is disposed on a side that is of the conductive layer 133 of the insulating substrate 13 and that faces away from the insulation layer 131.

As shown in FIG. 4, FIG. 5, and FIG. 6, in some embodiments, at least a part of the composite substrate 14 is accommodated in the mounting hole 22 and seals the accommodation cavity 21. The composite substrate 14 includes a first connecting piece 141 and a second connecting piece 142 that are connected. In the Z-axis direction, the first connecting piece 141 is connected to the insulating substrate 13, and a side wall 1423 of the second connecting piece 142 is connected to a hole wall of the mounting hole 22. A material of the first connecting piece 141 is different from a material of the second connecting piece 142. The material of the second connecting piece 142 is the same as a material of the heat sink 20. In the direction perpendicular to the thickness direction of the insulating substrate 13, a maximum size of the second connecting piece 142 is greater than or equal to a maximum size of the first connecting piece 141, and the direction perpendicular to the thickness direction of the insulating substrate 13 is the X-axis direction or the Y-axis direction. A thermal conductivity of the first connecting piece 141 is greater than a thermal conductivity of the second connecting piece 142. In this embodiment, both the first connecting piece 141 and the second connecting piece 142 are accommodated in the mounting hole 22, the first connecting piece 141 and the second connecting piece 142 jointly seal the accommodation cavity 21, and the coolant in the accommodation cavity 21 is in contact with the first connecting piece 141 and the second connecting piece 142.

For example, the material of the first connecting piece 141 is copper, and the material of the heat sink 20 and the material of the second connecting piece 142 are aluminum. In some other embodiments, the material of the first connecting piece 141 may be one of aluminum alloy, aluminum silicon (AlSi) alloy, magnesium alloy, steel, titanium alloy, aluminum silicon carbide (AlSiC), and zinc, and the material of the second connecting piece 142 and the material of the heat sink 20 may be another one of aluminum alloy, AlSi alloy, magnesium alloy, steel, titanium alloy, AlSiC, and zinc. The thermal conductivity of the first connecting piece 141 may alternatively be less than or equal to the thermal conductivity of the second connecting piece 142. It should be noted that, in this application, "a thermal conductivity of a component A" is a thermal conductivity of a material of the component A.

In this embodiment of this application, the at least a part of the composite substrate 14 is accommodated in the mounting hole 22 and seals the accommodation cavity 21, so that the coolant in the accommodation cavity 21 can be in contact with the composite substrate 14, and heat generated during operating of the power component 12 is transferred to the coolant through the composite substrate 14, and then transferred to an external environment through the coolant. The heat generated during operating of the power component 12 may not pass through the heat sink 20. This helps shorten a heat dissipation path of the power component 12, and the heat of the power component 12 can be diffused to the coolant more quickly. This helps improve heat dissipation efficiency on the power component 12.

In addition, in this application, the material of the second connecting piece 142 is designed to be the same as the material of the heat sink 20, so that the second connecting piece 142 can be fastened to the heat sink 20 through welding. This helps improve connection strength between the second connecting piece 142 and the heat sink 20, and helps improve structural stability and reliability. In addition, assembly is facilitated, processing efficiency is higher, and costs are reduced.

In addition, the composite substrate 14 may be first welded and fastened to the heat sink 20. After a welding temperature of the composite substrate 14 and the heat sink 20 decreases, the insulating substrate 13 and the power component 12 are mounted on the composite substrate 14, to prevent the welding temperature of the composite substrate 14 and the heat sink 20 from acting on the insulating substrate 13 and the power component 12. This avoids deformation of the insulating substrate 13 and the power component 12 due to an excessively high temperature, and a production yield is higher.

A design in which the thermal conductivity of the first connecting piece 141 is greater than the thermal conductivity of the second connecting piece 142 causes the first connecting piece 141 to have better thermal conductivity performance, and the heat of the power component 12 can be more quickly diffused to the coolant through the first connecting piece 141, thereby improving the heat dissipation efficiency on the power component 12.

As shown in FIG. 4, FIG. 5, and FIG. 6, in some embodiments, the first connecting piece 141 and the second connecting piece 142 enclose an accommodation groove 143, and in the Z-axis direction, an opening 1430 of the accommodation groove 143 faces away from the accommodation cavity 21. At least a part of the insulating substrate 13 is disposed in the accommodation groove 143 and is fastened and stacked to the first connecting piece 141. For example, the insulating substrate 13 and the power component 12 are accommodated in the accommodation groove 143. The first connecting piece 141 is disposed opposite to the opening 1430 of the accommodation groove 143.

In a manner including but not limited to sintering, welding, rolling, or bonding, the second connecting piece 142 is fastened and stacked to a side that is of the first connecting piece 141 and that faces away from the accommodation cavity 21 of the heat sink 20. In the X-axis direction, the maximum size of the second connecting piece 142 is equal to the maximum size of the first connecting piece 141, and the maximum size of the second connecting piece 142 is equal to a maximum size of the mounting hole 22. In the Y-axis direction, the maximum size of the second connecting piece 142 is equal to the maximum size of the first connecting piece 141, and the maximum size of the second connecting piece 142 is equal to the maximum size of the mounting hole 22.

In this embodiment, the mounting hole 22 is a rectangular hole, the maximum size of the mounting hole 22 in the X-axis direction is a length of the mounting hole 22, and the maximum size of the mounting hole 22 in the Y-axis direction is a width of the mounting hole 22. The first connecting piece 141 is a rectangular plate, the maximum size of the first connecting piece 141 in the X-axis direction is a length of the first connecting piece 141, and the maximum size of the first connecting piece 141 in the Y-axis direction is a width of the first connecting piece 141. The second connecting piece 142 is a rectangular plate, the maximum size of the second connecting piece 142 in the X-axis direction is a length of the second connecting piece 142, and the maximum size of the second connecting piece 142 in the Y-axis direction is a width of the second connecting piece 142.

In some other embodiments, the mounting hole 22 may alternatively be a circular hole, the maximum size of the mounting hole 22 in the X-axis direction is a diameter of the mounting hole 22, and the maximum size of the mounting hole 22 in the Y-axis direction is the diameter of the mounting hole 22. The first connecting piece 141 may alternatively be a circular plate, the maximum size of the first connecting piece 141 in the X-axis direction is a diameter of the first connecting piece 141, and the maximum size of the first connecting piece 141 in the Y-axis direction is the diameter of the first connecting piece 141. The second connecting piece 142 may alternatively be a circular plate, the maximum size of the second connecting piece 142 in the X-axis direction is a diameter of the second connecting piece 142, and the maximum size of the second connecting piece 142 in the Y-axis direction is the diameter of the second connecting piece 142.

The accommodation groove 143 penetrates the second connecting piece 142 in the Z-axis direction, and in the Z-axis direction, the opening 1430 of the accommodation groove 143 is opposite to the first connecting piece 141. Specifically, projection of the opening 1430 of the accommodation groove 143 in the Z-axis direction overlaps projection of the first connecting piece 141 in the Z-axis direction.

The insulating substrate 13 is accommodated in the accommodation groove 143. In a manner including but not limited to soldering, sintering, or brazing, the first connecting piece 141 is fastened and stacked to a side that is of the thermally conductive layer 132 of the insulating substrate 13 and that faces away from the insulation layer 131. Before the thermally conductive layer 132 is welded to the first connecting piece 141, an antioxidant plating layer made of an organic material may be first applied to a surface of the first connecting piece 141. This helps reduce a void rate of welding between the first connecting piece 141 and the thermally conductive layer 132, and helps improve effect and reliability of welding the first connecting piece 141 to the thermally conductive layer 132. In some other embodiments, the antioxidant plating layer may be replaced by another plating layer, for example, a Ni plating layer, an Ag plating layer, an Au plating layer, or a composite plating layer.

It may be understood that, in the Z-axis direction, the power component 12, the conductive layer 133, the insulation layer 131, and the thermally conductive layer 132 are sequentially disposed, and the first connecting piece 141 is fastened and stacked to the side that is of the thermally conductive layer 132 and that faces away from the insulation layer 131. The material of the first connecting piece 141 is the same as the material of the thermally conductive layer 132. A design in which the material of the first connecting piece 141 is the same as the material of the thermally conductive layer 132 helps improve connection strength between the first connecting piece 141 and the thermally conductive layer 132, helps improve structural stability, and causes the thermally conductive layer 132 to also have good thermal conductivity performance. The heat of the power component 12 can be better transferred to the first connecting piece 141, and then the first connecting piece 141 transfers the heat to the coolant in the accommodation cavity 21. This helps improve heat dissipation effect and heat dissipation efficiency of the power module 100.

The first connecting piece 141 and the second connecting piece 142 enclose the accommodation groove 143. In the Z-axis direction, the opening 1430 of the accommodation groove 143 faces away from the heat sink 20, and the at least a part of the insulating substrate 13 is disposed in the accommodation groove 143 and is fastened and stacked to the first connecting piece 141. This reduces a size of the power module 100 in the Z-axis direction, and makes a structure compact, thereby facilitating a miniaturization design. A design in which the second connecting piece 142 is fastened and stacked to the side that is of the first connecting piece 141 and that faces away from the accommodation cavity 21 of the heat sink 20, and the accommodation groove 143 penetrates the second connecting piece 142 in the Z-axis direction implements sealing of the accommodation cavity 21 only via the first connecting piece 141. This helps increase a contact area between the first connecting piece 141 and the coolant in the accommodation cavity 21, and helps improve the heat dissipation efficiency on the power component 12. In addition, the structure is simple, processing is facilitated, the processing efficiency is improved, and the processing costs are reduced.

A design in which the first connecting piece 141 is disposed opposite to the opening 1430 of the accommodation groove 143, and the insulating substrate 13 is fastened and stacked to the first connecting piece 141 causes the first connecting piece 141 to be in direct contact with the coolant in the accommodation cavity 21, and the heat generated during operating of the power component 12 to be transferred to the coolant through the insulating substrate 13 and the first connecting piece 141. This helps shorten the heat dissipation path of the power component 12, and helps improve the heat dissipation efficiency on the power component 12.

In some embodiments, a size of the first connecting piece 141 in the Z-axis direction is greater than the size of the thermally conductive layer 132 in the Z-axis direction. A design in which the size of the first connecting piece 141 in the Z-axis direction is greater than the size of the thermally conductive layer 132 in the Z-axis direction helps improve strength of the first connecting piece 141, helps improve reliability of the connection between the first connecting piece 141 and the insulating substrate 13, and helps improve the structural stability and the reliability of the power module 100.

As shown in FIG. 5 and FIG. 6, in some embodiments, the terminal 11 is disposed on the side that is of the conductive layer 133 of the insulating substrate 13 and that faces away from the insulation layer 131 and is connected to the conductive layer 133. The terminal 11 is electrically connected to the power component 12 through the conductive layer 133. The terminal 11 is disposed in the Z-axis direction. For example, there may be two terminals 11. The two terminals 11 are respectively a first terminal 11a and a second terminal 11b. In some other embodiments, there may be three, four, or more terminals 11.

In some embodiments, the packaging member 15 is made of a plastic packaging material including but not limited to epoxy resin or polyimide. In some other embodiments, the packaging member 15 may alternatively be made of another packaging material like a potting adhesive. The packaging member 15 is disposed on a side that is of the first connecting piece 141 and that faces the insulating substrate 13. Specifically, the packaging member 15 is disposed in the accommodation groove 143. The packaging member 15 wraps the entire insulating substrate 13, the entire power component 12, a part of the first terminal 11a, and a part of the second terminal 11b. An end part that is of the first terminal 11a and that faces away from the insulating substrate 13 is exposed outside the packaging member 15 and is mounted on the circuit board 200 (as shown in FIG. 2), and an end part that is of the second terminal 11b and that faces away from the insulating substrate 13 is exposed outside the packaging member 15 and is mounted on the circuit board 200. A direct current transmitted from the input terminal 300 (as shown in FIG. 1) is transmitted to the power component 12 through the first terminal 11a. The power component 12 is configured to convert the direct current into an alternating current. The alternating current output by the power component 12 is transmitted to the output terminal 400 (as shown in FIG. 1) through the second terminal 11b. The output terminal 400 receives the alternating current output by the power component 12, and transmits the alternating current to the power grid 3000 (as shown in FIG. 1), to supply the alternating current to the power grid 3000.

In some embodiments, the functional component 10 further includes a cover plate 19. The cover plate 19 is disposed on a side that is of the power component 12 and that faces away from the insulating substrate 13 and is sleeved outside the terminal 11. Specifically, in the Z-axis direction, the cover plate 19 is spaced from the power component 12, and the cover plate 19 is sleeved outside the first terminal 11a and the second terminal 11b. The packaging member 15 wraps a part of the cover plate 19, and a surface that is of the cover plate 19 and that faces away from the power component 12 is exposed outside the packaging member 15. In this embodiment, the cover plate 19 is disposed to prevent the packaging member 15 from overflowing, thereby ensuring that a structural form of the packaging member 15 is complete, and ensuring that the first terminal 11a and the second terminal 11b can be exposed outside the packaging member 15.

As shown in FIG. 4 and FIG. 5, in some embodiments, a side surface 1416 of the first connecting piece 141 is aligned with a surface 1422 that is of the second connecting piece 142 and that faces away from the accommodation groove 143. Specifically, rounded corners are disposed at both four corners of the first connecting piece 141 and four corners of the second connecting piece 142. Radiuses of the rounded corners of the four corners of the first connecting piece 141 are equal to radiuses of the rounded corners of the four corners of the second connecting piece 142, and the radiuses of the rounded corners of the four corners of the first connecting piece 141 and the radiuses of the rounded corners of the four corners of the second connecting piece 142 are both greater than 5 mm. In this embodiment, the rounded corners are disposed at the four corners of the mounting hole 22, the four corners of the first connecting piece 141, and the four corners of the second connecting piece 142, so that the side wall 1423 of the second connecting piece 142 is welded to the hole wall of the mounting hole 22, welding performance is better, and structural strength is better, thereby improving reliability. In some other embodiments, the four corners of the first connecting piece 141 and the four corners of the second connecting piece 142 may alternatively be set to oblique angles or right angles.

As shown in FIG. 4, FIG. 5, and FIG. 7, in some embodiments, a retaining wall 1411 is disposed on a surface that is of the first connecting piece 141 and that faces the insulating substrate 13, the retaining wall 1411 is in contact with the first connecting piece 141, and the retaining wall 1411 is located in the accommodation groove 143. The retaining wall 1411 surrounds the insulating substrate 13 and the power component 12 and is spaced from the insulating substrate 13 and the power component 12. The packaging member 15 wraps the retaining wall 1411. For example, the retaining wall 1411 is in a rectangular ring shape. In some other embodiments, the retaining wall 1411 may alternatively be in a circular ring shape or of another special-shaped structure. Rounded corners are disposed at four corners of the retaining wall 1411. In some other embodiments, the four corners of the retaining wall 1411 may alternatively be set to oblique angles or right angles. The retaining wall 1411 and a groove side wall of the accommodation groove 143 are spaced, and the groove side wall of the accommodation groove 143 is a side wall that is of the second connecting piece 142 and that faces the insulating substrate 13. In other words, the retaining wall 1411 and the second connecting piece 142 are spaced. In a thickness direction of the retaining wall 1411, a ratio of a minimum spacing D between the retaining wall 1411 and the groove side wall of the accommodation groove 143 to a groove depth H of the accommodation groove 143 is greater than 0.25.

In this embodiment, a design in which the retaining wall 1411 is disposed on the surface that is of the first connecting piece 141 and that faces the insulating substrate 13, and the packaging member 15 wraps the retaining wall 1411 improves binding force between the packaging member 15 and the composite substrate 14, and improves stability of a connection between the packaging member 15 and the composite substrate 14. The ratio of the minimum spacing D between the retaining wall 1411 and the second connecting piece 142 to the groove depth H of the accommodation groove 143 is designed to be greater than 0.25, so that there is large space between the retaining wall 1411 and the groove side wall (for example, the second connecting piece 142 shown in the figure) of the accommodation groove 143. This helps the packaging member 15 fill space between the retaining wall 1411 and the groove side wall of the accommodation groove 143, helps improve the binding force between the packaging member 15 and the composite substrate 14, and further improves reliability.

As shown in FIG. 4, FIG. 7, and FIG. 8, in some embodiments, a first protrusion 1414 and a circulation hole 1415 are disposed on the retaining wall 1411, the first protrusion 1414 is disposed on a side of the retaining wall 1411 in the thickness direction (namely, a direction perpendicular to the Z-axis direction) of the retaining wall 1411, a cross section of the retaining wall 1411 is L-shaped, and the cross section of the retaining wall 1411 is perpendicular to a length direction of the retaining wall 1411. In the Z-axis direction, the first protrusion 1414 is spaced from the first connecting piece 141. The first protrusion 1414 faces the insulating substrate 13. In some other embodiments, the first protrusion 1414 may alternatively be disposed on a side that is of the retaining wall 1411 and that faces the second connecting piece 142. Alternatively, first protrusions 1414 are disposed on two sides of the retaining wall 1411 in the thickness direction of the retaining wall 1411, so that the cross section of the retaining wall 1411 is T-shaped.

The circulation hole 1415 penetrates the retaining wall 1411 in the thickness direction of the retaining wall 1411, the circulation hole 1415 penetrates the retaining wall 1411 in the Z-axis direction, and a size of the circulation hole 1415 in the length direction of the retaining wall 1411 is greater than a size of the retaining wall 1411 in the Z-axis direction. In this embodiment, there are a plurality of circulation holes 1415, and the plurality of circulation holes 1415 are evenly spaced in the length direction of the retaining wall 1411. In some other embodiments, the plurality of circulation holes 1415 may alternatively be unevenly spaced in the length direction of the retaining wall 1411, and there may alternatively be one circulation hole 1415.

In this embodiment, in a process in which the packaging member 15 fills the accommodation groove 143, the packaging member 15 flows from the retaining wall 1411 to a gap between the retaining wall 1411 and the second connecting piece 142 through the circulation hole 1415, or flows from the gap between the retaining wall 1411 and the second connecting piece 142 to the retaining wall 1411 through the circulation hole 1415. The circulation hole 1415 is designed. This helps improve fluidity of the packaging member 15 in the accommodation groove 143, so that the packaging member 15 can fill the entire accommodation groove 143, and a hole is prevented. This helps improve the binding force between the packaging member 15 and the composite substrate 14, thereby improving reliability. In a design in which the size of the circulation hole 1415 in the length direction of the retaining wall 1411 is greater than the size of the retaining wall 1411 in the Z-axis direction, the size of the circulation hole 1415 is larger, so that the fluidity of the packaging member 15 is better.

In addition, the packaging member 15 flows into a gap between the first protrusion 1414 and the first connecting piece 141, a part of the packaging member 15 is located between the first protrusion 1414 and the first connecting piece 141, and the first protrusion 1414 limits the packaging member 15 in the Z-axis direction. This further improves the stability of the connection between the packaging member 15 and the composite substrate 14. In some other embodiments, the retaining wall 1411 may be omitted.

As shown in FIG. 4, FIG. 5, and FIG. 6, in some embodiments, a first groove 1413 is disposed on the surface that is of the first connecting piece 141 and that faces the insulating substrate 13, the first groove 1413 is located in the retaining wall 1411, and in the Z-axis direction, the first groove 1413 is opposite to the thermally conductive layer 132 of the insulating substrate 13, and the first groove 1413 is close to an edge of the thermally conductive layer 132 of the insulating substrate 13. For example, there are a plurality of first grooves 1413, the plurality of first grooves 1413 are arranged in rectangles, and in the Z-axis direction, the plurality of first grooves 1413 are opposite to the thermally conductive layer 132 of the insulating substrate 13, and the plurality of first grooves 1413 are close to the edge of the thermally conductive layer 132 of the insulating substrate 13. In some other embodiments, there may be one first groove 1413.

In this embodiment, the first groove 1413 is disposed, and the first groove 1413 is close to the edge of the insulating substrate 13, so that stress generated at the edge of the insulating substrate 13 can be released in the first groove 1413, thereby preventing the stress from directly acting on the first connecting piece 141, and preventing the first connecting piece 141 from being deformed and damaging the insulating substrate 13 and the power component 12. This helps prolong a service life of the power module 100, and further prolongs a service life of the power conversion device 1000.

In some embodiments, a second groove 1412 is disposed on a surface that is of the first connecting piece 141 and that faces away from the insulating substrate 13, the second groove 1412 is opposite to and communicates with the accommodation cavity 21, and the coolant in the accommodation cavity 21 flows into the second groove 1412. For example, there are a plurality of second grooves 1412, and the plurality of second grooves 1412 are sequentially spaced in the direction perpendicular to the Z-axis direction. In this embodiment, the plurality of second grooves 1412 are sequentially spaced in the X-axis direction. In some other embodiments, there may be one second groove 1412.

In this embodiment, the second groove 1412 is disposed on the surface that is of the first connecting piece 141 and that faces away from the insulating substrate 13, and when the first connecting piece 141 is accommodated in the mounting hole 22, the second groove 1412 is opposite to and communicates with the accommodation cavity 21. The second groove 1412 increases the contact area between the first connecting piece 141 and the coolant in the accommodation cavity 21, and helps improve the heat dissipation efficiency on the power component 12. In addition, the coolant in the accommodation cavity 21 flows into the second groove 1412, and the coolant is closer to the power component 12. This shortens the heat dissipation path, and helps improve the heat dissipation effect. In some other embodiments, a fin may alternatively be disposed on the surface that is of the first connecting piece 141 and that faces away from the insulating substrate 13. The fin may increase the contact area between the first connecting piece 141 and the coolant in the accommodation cavity 21, and helps improve the heat dissipation efficiency on the power component 12. In some other embodiments, both the second groove 1412 and the fin may be disposed on the surface that is of the first connecting piece 141 and that faces away from the insulating substrate 13. In other words, the second groove 1412 and/or the fin are/is disposed on the surface that is of the first connecting piece 141 and that faces away from the insulating substrate 13.

As shown in FIG. 7 and FIG. 8, in some embodiments, a second protrusion 1431 is disposed on the groove side wall of the accommodation groove 143, and the second protrusion 1431 faces the insulating substrate 13. Specifically, the second protrusion 1431 is disposed on a side that is of the second connecting piece 142 and that faces the insulating substrate 13. In the Z-axis direction, the second protrusion 1431 is spaced from the first connecting piece 141. In the process in which the packaging member 15 fills the accommodation groove 143, the packaging member 15 flows into a gap between the second protrusion 1431 and the first connecting piece 141, a part of the packaging member 15 is located between the second protrusion 1431 and the first connecting piece 141, and the second protrusion 1431 limits the packaging member 15 in the Z-axis direction. This further improves the stability of the connection between the packaging member 15 and the composite substrate 14.

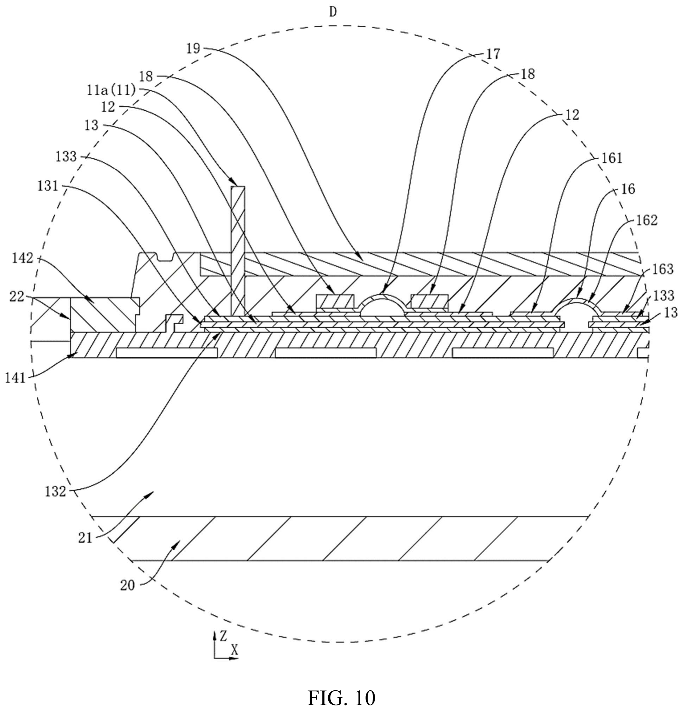

Refer to FIG. 9 and FIG. 10. With reference to FIG. 3, FIG. 9 is a sectional view of the power module 100 shown in FIG. 3 cut along the line L1-L1 according to another embodiment. FIG. 10 is an enlarged view of the power module 100 shown in FIG. 9 in a position D.

As shown in FIG. 9 and FIG. 10, in some embodiments, there are a plurality of insulating substrates 13 and a plurality of power components 12. In the direction perpendicular to the Z-axis direction, the plurality of insulating substrates 13 are sequentially spaced. Specifically, in the X-axis direction, the plurality of insulating substrates 13 are sequentially spaced. At least one power component 12 is disposed on a side that is of each insulating substrate 13 and that faces away from the heat sink 20. For example, a plurality of power components 12 are disposed on the side that is of each insulating substrate 13 and that faces away from the heat sink 20, and the plurality of power components 12 disposed on the insulating substrate 13 are spaced from each other.

The functional component 10 further includes a first conductive member 16, a second conductive member 17, and a thermally conductive member 18. The first conductive member 16 is disposed between two adjacent insulating substrates 13, and one end of the first conductive member 16 is connected to a conductive layer 133 of one insulating substrate 13, and the other end of the first conductive member 16 is connected to a conductive layer 133 of the other insulating substrate 13.

Specifically, the first conductive member 16 is a metal clip, for example, may be a copper clip. The first conductive member 16 includes a first fastening part 161, a first middle part 162, and a second fastening part 163 that are sequentially fastened. In the X-axis direction, the first fastening part 161, the first middle part 162, and the second fastening part 163 are sequentially fastened. In the Z-axis direction, both the first fastening part 161 and the second fastening part 163 are perpendicular to the Z-axis direction, and the first middle part 162 is in an arc-shaped sheet shape. In a manner including but not limited to soldering, sintering, or brazing, the first fastening part 161 is fastened and stacked to a side that is of the conductive layer 133 of the insulating substrate 13 and that faces away from the insulation layer 131, and the second fastening part 163 is fastened and stacked to a side that is of the conductive layer 133 of the other insulating substrate 13 and that faces away from the insulation layer 131. In this way, the conductive layers 133 of the two adjacent insulating substrates 13 are electrically connected, and further, power components 12 on the two adjacent insulating substrates 13 are electrically connected. In some other embodiments, the first conductive member 16 may alternatively be disposed as a conducting wire, and a volume of the conducting wire is small. This helps reduce a volume of the power module 100, and facilitates a miniaturization design.

The second conductive member 17 is disposed on the side that is of the power component 12 and that faces away from the insulating substrate 13. One end of the second conductive member 17 is connected to one power component 12, and the other end of the second conductive member 17 is connected to the other power component 12. Specifically, one end of the second conductive member 17 is fastened to a side that is of the power component 12 and that faces away from the insulating substrate 13, and the other end of the second conductive member 17 is fastened to a side that is of the other power component 12 and that faces away from the insulating substrate 13. An electrical connection between different power components 12 can be implemented via the second conductive member 17. For a structure of the second conductive member 17, refer to the related descriptions of the first conductive member 16. Details are not described again. The thermally conductive member 18 is disposed on the side that is of the power component 12 and that faces away from the insulating substrate 13. The thermally conductive member 18 may be in contact with the power component 12. The thermally conductive member 18 may alternatively be disposed on a side that is of the second conductive member 17 and that faces away from the insulating substrate 13.

The first terminal 11a is disposed on a side that is of a conductive layer 133 of one insulating substrate 13 and that faces away from the insulation layer 131 and is connected to the conductive layer 133, and the second terminal 11b is disposed on a side that is of a conductive layer 133 of the other insulating substrate 13 and that faces away from the insulation layer 131 and is connected to the conductive layer 133. A direct current transmitted from the input terminal 300 (as shown in FIG. 1) is transmitted to the plurality of power components 12 through the first terminal 11a. The plurality of power components 12 are configured to convert the direct current into an alternating current. The alternating current output by the plurality of power components 12 is transmitted to the output terminal 400 (as shown in FIG. 1) through the second terminal 11b. The output terminal 400 receives the alternating current output by the plurality of power components 12, and transmits the alternating current to the power grid 3000 (as shown in FIG. 1), to supply the alternating current to the power grid 3000.

In this embodiment, the plurality of insulating substrates 13 and the plurality of power components 12 are disposed, so that performance of the power module 100 is stronger. A design in which the first conductive member 16 is disposed between the two adjacent insulating substrates 13 implements through-current between the two adjacent insulating substrates 13, so that in the two adjacent insulating substrates 13, the through-current can be implemented between a power component 12 disposed on one insulating substrate 13 and a power component 12 disposed on the other insulating substrate 13. This helps reduce stray inductance in a circuit, to reduce oscillation and overvoltage risks in the circuit, and helps improve the performance of the power module 100, thereby improving performance of the power conversion device 1000. A design in which the thermally conductive member 18 is disposed on a side that is of the power component 12 and that faces away from the insulating substrate 13 causes the heat of the power component 12 to be transferred to the thermally conductive member 18, and then the thermally conductive member 18 transfers the heat to the outside, thereby improving the heat dissipation effect on the power component 12.

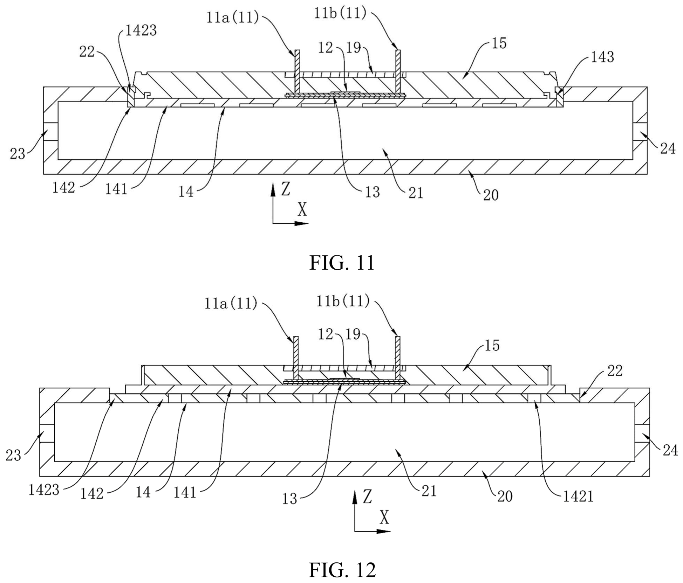

Refer to FIG. 11. With reference to FIG. 5, FIG. 11 is a sectional view of the power module 100 shown in FIG. 3 cut along the line L1-L1 according to still another embodiment.

As shown in FIG. 5 and FIG. 11, the power module 100 shown in FIG. 11 is similar to the power module 100 shown in FIG. 5. A difference between the power module 100 shown in FIG. 11 and the power module 100 shown in FIG. 5 lies in that the first connecting piece 141 and the second connecting piece 142 enclose the accommodation groove 143 in different manners. Specifically, in the embodiment shown in FIG. 11, the second connecting piece 142 encloses and wraps at least a part of a side wall of the first connecting piece 141. For example, the second connecting piece 142 encloses and wraps all of the side wall of the first connecting piece 141. In the X-axis direction, the maximum size of the second connecting piece 142 is greater than the maximum size of the first connecting piece 141, and the maximum size of the second connecting piece 142 is equal to the maximum size of the mounting hole 22. In the Y-axis direction, the maximum size of the second connecting piece 142 is greater than the maximum size of the first connecting piece 141, and the maximum size of the second connecting piece 142 is equal to the maximum size of the mounting hole 22. In addition, the size of the second connecting piece 142 in the Z-axis direction is greater than the size of the first connecting piece 141 in the Z-axis direction. A surface that is of the first connecting piece 141 and that faces the accommodation cavity 21 is aligned with a surface that is of the second connecting piece 142 and that faces the accommodation cavity 21. In some other embodiments, the surfaces may not be aligned with each other.

In this embodiment, in a design in which the second connecting piece 142 encloses and wraps the at least a part of the side wall of the first connecting piece 141, when the first connecting piece 141 is under pressure of the coolant in the accommodation cavity 21, it is more difficult for the first connecting piece 141 to deform, to avoid damage to the insulating substrate 13 and the power component 12 caused by deformation of the first connecting piece 141. This helps prolong the service life of the power module 100, and further prolongs the service life of the power conversion device 1000.

A design in which the size of the second connecting piece 142 in the Z-axis direction is greater than the size of the first connecting piece 141 in the Z-axis direction causes the first connecting piece 141 to be better wrapped by the second connecting piece 142, and when the first connecting piece 141 is under pressure of the coolant in the accommodation cavity 21, it is more difficult for the first connecting piece 141 to deform, to avoid the damage to the insulating substrate 13 and the power component 12 caused by the deformation of the first connecting piece 141, and further prolong the service life of the power module 100. In addition, this helps increase a connection area between the second connecting piece 142 and the hole wall of the mounting hole 22, helps improve connection strength, and helps improve the structural stability of the power module 100.

It may be understood that, in the embodiment shown in FIG. 11, the design in which the second connecting piece 142 encloses and wraps the at least a part of the side wall of the first connecting piece 141, and the size of the second connecting piece 142 in the Z-axis direction is greater than the size of the first connecting piece 141 in the Z-axis direction may be applied to the embodiment shown in any one of FIG. 1 to FIG. 10.

Refer to FIG. 12. With reference to FIG. 5, FIG. 12 is a sectional view of the power module 100 shown in FIG. 3 cut along the line L1-L1 according to yet another embodiment.

As shown in FIG. 5 and FIG. 12, the power module 100 shown in FIG. 12 is similar to the power module 100 shown in FIG. 5. A difference between the power module 100 shown in FIG. 12 and the power module 100 shown in FIG. 5 lies in that the first connecting piece 141 and the second connecting piece 142 are connected in different manners. In the embodiment shown in FIG. 12, the first connecting piece 141 is fastened and stacked to the insulating substrate 13 in a manner including but not limited to welding, bonding, or the like, and the second connecting piece 142 is fastened and stacked to a side that is of the first connecting piece 141 and that faces away from the insulating substrate 13. In the X-axis direction, the maximum size of the second connecting piece 142 is greater than the maximum size of the first connecting piece 141, and the maximum size of the second connecting piece 142 is equal to the maximum size of the mounting hole 22. In the Y-axis direction, the maximum size of the second connecting piece 142 is greater than the maximum size of the first connecting piece 141, and the maximum size of the second connecting piece 142 is equal to the maximum size of the mounting hole 22. Both the first connecting piece 141 and the second connecting piece 142 are accommodated in the mounting hole 22, the first connecting piece 141 is spaced from the hole wall of the mounting hole 22, and the second connecting piece 142 is fastened to the hole wall of the mounting hole 22 through welding. In the Z-axis direction, the second connecting piece 142 is opposite to the accommodation cavity 21. A design in which the side wall of the first connecting piece 141 is spaced from the hole wall of the mounting hole 22 facilitates extension of the welding torch into the mounting hole 22, to weld the side wall of the second connecting piece 142 to the hole wall of the mounting hole 22. In some other embodiments, the first connecting piece 141 may alternatively be located outside the mounting hole 22.

In a design in which the second connecting piece 142 is fastened and stacked to the side that is of the first connecting piece 141 and that faces away from the insulating substrate 13, the second connecting piece 142 seals the accommodation cavity 21, the second connecting piece 142 can resist the pressure of the coolant in the accommodation cavity 21, and the pressure of the coolant does not directly act on the first connecting piece 141. This prevents the first connecting piece 141 from being deformed, avoids the damage to the insulating substrate 13 and the power component 12, and helps prolong the service life of the power module 100, thereby prolonging the service life of the power conversion device 1000.

In the embodiment shown in FIG. 12, a through hole 1421 is disposed on a surface that is of the second connecting piece 142 and that faces away from the first connecting piece 141, and the through hole 1421 penetrates the second connecting piece 142 in the Z-axis direction. For example, there are a plurality of through holes 1421, and the plurality of through holes 1421 are sequentially spaced in the direction perpendicular to the Z-axis direction. Specifically, in the X-axis direction, the plurality of through holes 1421 are sequentially spaced. In some other embodiments, the through hole 1421 may not penetrate the second connecting piece 142. The through hole 1421 is opposite to and communicates with the accommodation cavity 21, and the coolant in the accommodation cavity 21 flows into the through hole 1421, so that the coolant can be in contact with the first connecting piece 141.

The through hole 1421 is disposed on the second connecting piece 142, so that the coolant can flow into the through hole 1421, and the first connecting piece 141 can be in direct contact with the coolant. Therefore, a distance between the power component 12 and the coolant is shorter, the heat dissipation path is shorter, and the heat of the power component 12 can be diffused to the coolant more quickly, thereby improving the heat dissipation effect of the power module 100.

It may be understood that, in the embodiment shown in FIG. 12, the design in which the first connecting piece 141 is fastened and stacked to the insulating substrate 13, the second connecting piece 142 is fastened and stacked to the side that is of the first connecting piece 141 and that faces away from the insulating substrate 13, the through hole 1421 is disposed on the surface that is of the second connecting piece 142 and that faces away from the first connecting piece 141 may be applied to the embodiment shown in any one of FIG. 1 to FIG. 11.

The foregoing descriptions are merely some embodiments and implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A power module, wherein the power module comprises a power component, an insulating substrate, a composite substrate, and a heat sink;
in a thickness direction of the insulating substrate, the power component, the insulating substrate, the composite substrate, and the heat sink are sequentially disposed; the heat sink comprises an accommodation cavity and a mounting hole; and in the thickness direction of the insulating substrate, the mounting hole is located on a side of the accommodation cavity and communicates with the accommodation cavity, and at least a part of the composite substrate is accommodated in the mounting hole and seals the accommodation cavity; and
the composite substrate comprises a first connecting piece and a second connecting piece that are connected; in the thickness direction of the insulating substrate, the first connecting piece is connected to the insulating substrate, a side wall of the second connecting piece is connected to a hole wall of the mounting hole, and a material of the second connecting piece is the same as a material of the heat sink; and in a direction perpendicular to the thickness direction of the insulating substrate, a maximum size of the second connecting piece is greater than or equal to a maximum size of the first connecting piece.

2. The power module according to claim 1, wherein a thermal conductivity of the first connecting piece is greater than a thermal conductivity of the second connecting piece.

3. The power module according to claim 1, wherein the first connecting piece and the second connecting piece enclose an accommodation groove; and in the thickness direction of the insulating substrate, an opening of the accommodation groove faces away from the accommodation cavity, and at least a part of the insulating substrate is disposed in the accommodation groove and is fastened and stacked to the first connecting piece.

4. The power module according to claim 3, wherein the second connecting piece is fastened and stacked to a side that is of the first connecting piece and that faces away from the accommodation cavity, and the accommodation groove penetrates the second connecting piece in the thickness direction of the insulating substrate.

5. The power module according to claim 3, wherein the second connecting piece encloses and wraps at least a part of a side wall of the first connecting piece.

6. The power module according to claim 5, wherein a size of the second connecting piece in the thickness direction of the insulating substrate is greater than a size of the first connecting piece in the thickness direction of the insulating substrate.

7. The power module according to any one of claims 3 to 6, wherein the power module further comprises a packaging member, and the packaging member wraps the insulating substrate and the power component.

8. The power module according to claim 7, wherein a retaining wall is disposed on a surface that is of the first connecting piece and that faces the insulating substrate; the retaining wall surrounds the insulating substrate, and the retaining wall and the second connecting piece are spaced; and the packaging member wraps the retaining wall.

9. The power module according to claim 8, wherein a first protrusion is disposed on a side of the retaining wall in a thickness direction of the retaining wall, the first protrusion faces the insulating substrate, and a part of the packaging member is located between the first protrusion and the first connecting piece.

10. The power module according to claim 8 or 9, wherein the retaining wall and a groove side wall of the accommodation groove are spaced; a circulation hole is disposed on the retaining wall; and the circulation hole penetrates the retaining wall in the thickness direction of the retaining wall, and the circulation hole penetrates the retaining wall in the thickness direction of the insulating substrate.

11. The power module according to any one of claims 7 to 10, wherein a second protrusion is disposed on the groove side wall of the accommodation groove, the second protrusion faces the insulating substrate, and a part of the packaging member is located between the second protrusion and the first connecting piece.

12. The power module according to claim 1, wherein the first connecting piece is fastened and stacked to the insulating substrate, and the second connecting piece is fastened and stacked to a side that is of the first connecting piece and that faces away from the insulating substrate.

13. The power module according to claim 12, wherein a through hole is disposed on a surface that is of the second connecting piece and that faces away from the first connecting piece.

14. The power module according to any one of claims 1 to 13, wherein the insulating substrate comprises a thermally conductive layer, an insulation layer, and a conductive layer that are sequentially disposed in the thickness direction of the insulating substrate, the conductive layer faces the power component, the first connecting piece is fastened and stacked to a side that is of the thermally conductive layer and that faces away from the insulation layer, and the size of the first connecting piece in the thickness direction of the insulating substrate is greater than a size of the thermally conductive layer in the thickness direction of the insulating substrate.

15. A power conversion device, wherein the power conversion device comprises a circuit board and the power module according to any one of claims 1 to 14, and the power module is mounted on the circuit board.
